# EUROPEAN PATENT SPECIFICATION

(11) **EP 2 800 113 B1**
(45) Date of publication and mention of the grant of the patent: **16.03.2016**
(21) Application number: 13460027.9
(22) Date of filing: 29.04.2013
(51) Int. Cl.: H01F 38/20

(54) **High voltage dry instrument transformer**
Hochspannungstrockeninstrumententransformator
Transformateur de mesure sec à haute tension

(43) Date of publication of application: 05.11.2014
(73) Proprietor: ABB Technology AG, 8050 Zürich (CH)
(72) Inventor: Banaszczyk, Jedrzej, 30-611 Krakow (PL); Czyzewski, Jan, 30-379 Krakow (PL); Adamczyk, Bartlomiej, 34-735 Niedzwiedz (PL); Wysocki, Wojciech, 31-271 Krakow (PL); Bachorz, Lukasz, 64-330 Opalenica (PL); Grysztar, Pawel, 38-440 Iwonicz Zdroj (PL); Tzavalas, Spiros, 5426 Lengnau, Aargau (CH); Kruesi, Urs, 8542 Wiesendangen (CH); Meier, Patrick, 5603 Staufen (CH); Sjogren, Lars, 771 94 Ludvika (SE)
(74) Representative: Chochorowska-Winiarska, Krystyna

(56) References cited:
- EP-A1- 0 129 819
- DE-A1- 1 926 097
- GB-A- 756 619
- US-A- 3 001 005

## Description

### BACKGROUND

The subject of invention is a HV (High Voltage) dry instrument transformer based on a new type of dry insulation system.

From the GB742554 patent description there is known an instrument transformer which has current transformer windings at least partially embedded in a closed end of a hollow insulating member of tubular shape made of synthetic thermosetting resin. The insulating member has potential gradient control means which are at least partly embedded in the walls of the insulating member. The outer surface of the closed end of the insulating member is provided with electrically conducting coating which is connected to the primary winding of the current transformer. Weathersheds are provided which may be integral with the insulating member. The potential gradient control means comprises overlapping cylindrical condenser plates embedded in the walls of the insulating members. The insulating member is preferably manufactured by a centrifugal casting process forming the subject of Specification GB 742 413. The current transformer core is a ring embedded in the head of the insulating member. The HV primary winding is reduced to a rod passing through the transformer core. The low-votage (LV) secondary winding is wound around this core and is embedded with it in the insulating material. The radial electric field in the vicinity of the rod is very high, much higher than the average field between the rod and the secondary winding. Due to this nonuniformity of the field the distances between those LV and HV elements must be very large to guarantee the necessary dielectric strength of the insulation system. The potential gradient control means in the column of the transformer, which are placed only close to the external surface of the column, provide only the grading of the axial field, while the radial field in the column is ungraded. The resulting high electric field around the secondary winding leads in the top part of the apparatus causes the radial field to be highly non-uniform requiring a large radial insulation distance. All these requirements contribute to a substantial increase of the dimensions of the apparatus.

The GB742554 patent decsriprion discloses also a dry voltage transformer in which the primary winding is placed vertically along the column insulator close to its outer surface, providing in the same time the grading of the axial electric field along the column. The radial electric field in the column is ungraded and thus, especially in the area close to the head of the transformer, strongly non-uniform, resulting in a requirement of large insulation distances and large diameter of the column.

The resulting large size of the instrument transfomer is the disadvantage of the solution described. The large size, and the resulting large weight of the instrument transformer, leads to large mechanical stresses when the apparatus is dynamically loaded, e.g. in case of strong wind or an earthquake.

The large size of the instrument transformer causes also difficulties in manufacturing of the transformer. During the process of hardening of the synthetic resins there occurs chemical and thermal shrinkage of the material leading to mechanical stresses in the hardened structure. The exothermic nature of the process and low thermal conductivity of the resins make these mechanical stresses strongly increase with the increasing size of the hardened structure causing a risk of producing voids or cracks inside the insulation material leading to partial discharges and to electrical failure of the apparatus. This causes a size limitation for the apparatus, which, in turn limits the voltage level at which the instrument transformer can be applied.

### SUMMARY

The essence of a HV dry instrument transformer according to the invention, which has a form of a current transformer or a voltage transformer as claimed in claim 1, wherein the current transformer is provided with a column comprising a column insulating body for electric insulation of leads of a secondary winding assembly and the voltage transformer is provided with a column comprising a column insulating body for electric insulation of a lead of primary winding and the column insulating bodies are in contact with an insulating members is that the column insulating bodies have a form of a dry capacitor bushings, wound as a block of spacer sheet and the column insulating bodies have an impregnation material having substantially the same coefficient of thermal expansion as the material of the insulating members.

Preferably the insulating members are made of an inorganic-filled hardenable resin.

Preferably the impregnation material for impregnating the column insulating bodies is an inorganic-filled hardenable resin.

Preferably the impregnation material for impregnating the head insulating body of the current transformer is an inorganic-filled hardenable resin.

Preferable the inorganic- filled hardenable resin is an epoxy resin filled with quartz powder.

Preferably the head insulating body and the column insulating bodies, have grading layer systems with field grading layers for capacitive field control and in each grading system and the field-grading layers are spaced from each other by a first and second block of spacer sheet for the current transformer or by a block of spacer sheet of the column insulating body for the voltage transformer.

Preferably the block of spacer sheets are made of polymer fibers.

Preferably the outer surface of the secondary winding assembly of the current transformer is covered by an electrically conductive winding shield.

Preferably the winding shield is made of metal or electrically conductive polymer material or is made from paper filled with conductive particles or woven or nonwoven material made of electrically conductive fibers.

Preferably the outer surface of the insulating members are covered by an electrically conductive encapsulation.

Preferably the electrically conductive encapsulations are made of an electrically conductive paint.

Preferably the electrically conductive paint is based on epoxy resin filled with electrically conductive particles, preferably carbon-black.

Alternatively the electrically conductive encapsulations are made as a metallic mesh or grid embedded in the outer surface of the material forming the insulating members.

Preferably the HV dry instrument transformer has an external insulator of the column of the current transformer or an external insulator of the column of the voltage transformer which is made of a silicon elastomer directly molded on the inner part of the column of the current transformer or on the inner part of the column of the voltage transformer.

Preferably an external insulator of the column of the current transformer or an external insulator of the column of the voltage transformer is made of an inorganic-filled hardenable resin.

### ADVANTAGES

The instrument transformer in the form of the current transformer comprises two elements with capacitive field grading systems providing the grading of both the radial and the axial field in those elements. The substantially uniform radial electric field in the insulating elements allows for effective exploiting of the field strength of the insulating material applied and consequently for minimizing the diameters of the elements. Those capacitively graded elements, both having a form of dry capacitor bushings, are made of a porous spacer sheet material impregnated with a hardenable resin. The space bridging the two bushing insulators, as well as the volume in the current transformer head is filled with a hardenable resin identical or similar to that used for impregnation the capacitive busing, in such a way that the thermal expansion coefficients of both materials are substantially identical.

The instrument transformer in the form of the voltage transformer comprises one insulating element with capacitive field grading system providing the grading of both the axial and radial field in the element. Similarly to the current transformer, the capacitive graded element has a form of a bushing insulator made of a porous spacer sheet material impregnated with a hardenable resin. The space bridging the capacitively graded element and the dry insulation of the primary winding is filled with a hardenable resin identical or similar to that used for impregnation of the busing insulator and for the primary winding, so that the thermal expansion coefficients of those three components are substantially identical.

The small size and the simple shape of the capacitively graded elements allows for manufaturing those using hardenable resins without generating large mechanical stresses or producing voids or cracks. The material of the insulating member can be filled into the appropriate space in a separate proces so as it adheres firmly to the matching elemnets of the construction. The substantially identical coefficeint of thermal expansion of the insulating member and the capacitively graded elements, as well as of the primary winding of the voltage transfomrer allows for maintaining this adhesion in the broad span of operating temperatures of the apparatus.

The instrument transformer is compact and light-weight, thus reducing the mechanical stresses, to which the relatively high column of the current transformer or insulator column of the voltage transformer is exposed when loaded dynamically, e.g. in case of strong wind or an earthquake.

### DETAILED DESCRIPTION

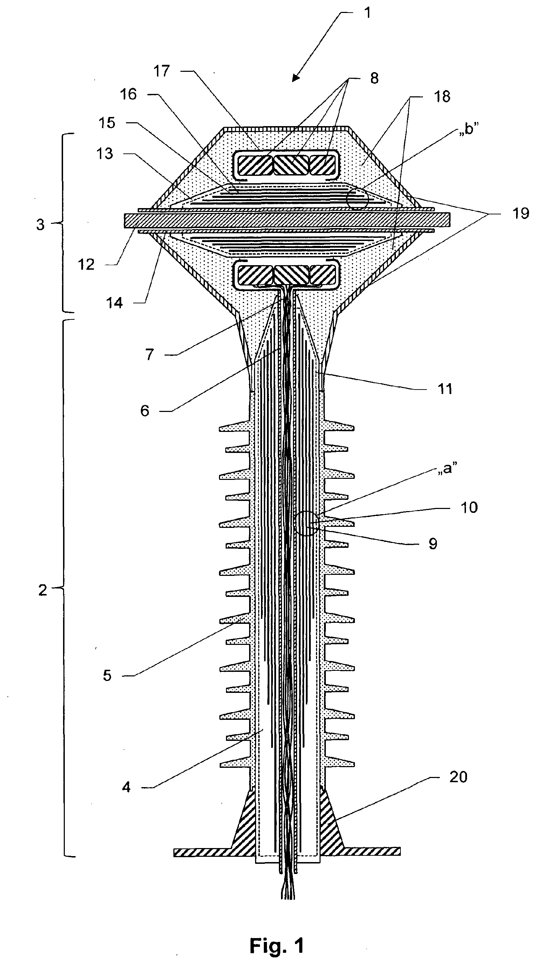

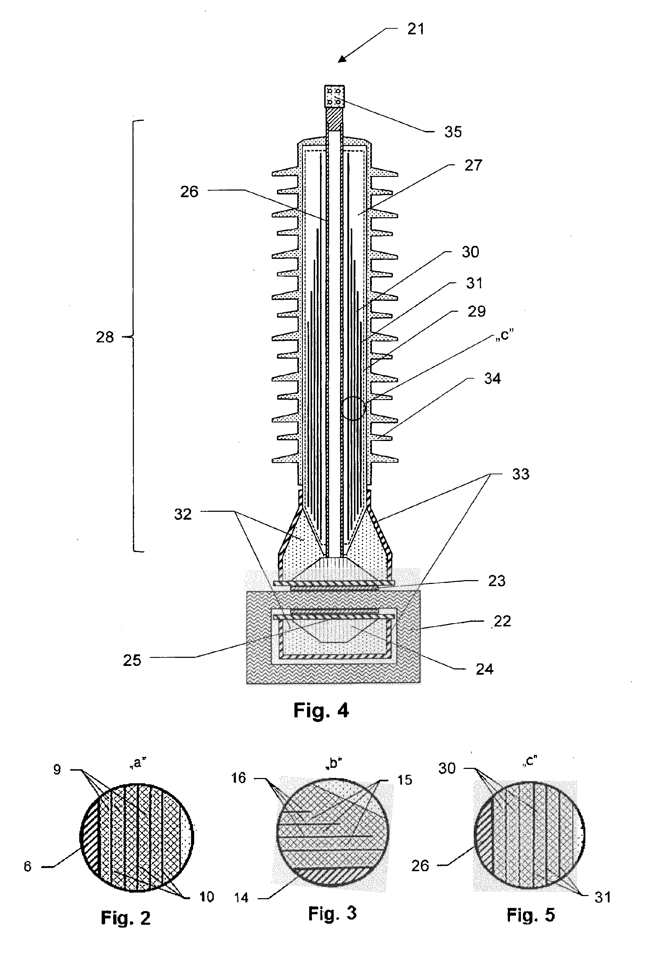

The HV dry instrument transformer according to the invention is presented on the drawing in a cross-section view, where fig.1 shows a current transformer, fig.2 shows the detail "a" from fig.1, fig.3 shows the detail "b" from fig.1, fig.4 shows a voltage transformer and fig.5 - the detail "c" from fig.3.

The instrument transformer has a form of a current transformer 1 or a voltage transformer 21. Both current and voltage transformers can also be carried out as a combined instrument transformer what is not presented on the drawing.

The current transformer 1 comprises a column 2 on which a transformer head 3 is supported. The column 2 has a form of an elongated tube mounted on a grounded box, not shown in the drawing, which comprises an inner part 4 and an external insulator 5 built up around the inner part 4. The inner part of the column 2 contains a secondary winding lead tube 6 through which the secondary winding leads 7 are running from at least one secondary winding assembly 8 located inside the head 3 of the transformer. Around the tube 6 a first block of spacer sheet 9 is wound, together with field-grading layers 10 inserted in between the sheets of the spacer and having outwardly diminishing axial length, forming a column insulating body 11 of the current transformer 1. The secondary winding assembly 8 can be arranged in a known manner, around annular iron cores, or can be made as a Rogowski coil, without a magnetic core. The primary winding, consisting of a primary conductor 12, runs through a head insulating body 13, constructed as a dry capacitor bushing which is placed in the head 3. The head insulating body 13 can be built-up around a primary conductor tube 14, or can be built-up directly around the conductor 12, what is not presented on the drawing. The head insulating body 13 has a field-grading layer system which is built-up by winding insulating layers of a second block of spacer sheet 15 onto the tube 14, or directly on the conductor 12, and inserting electrically conductive field-grading layers 16 of head insulating body 13 with outwardly diminishing axial length between the layers of the spacer sheet material. After winding, the head insulating body 13 is impregnated with hardenable resin in a suitable mold and hardened. Alternatively, the head insulating body 13 can also be wound on a mandrel which is withdrawn after the hardening of the resin resulting in the insulating body without the tube which consturction is not shown in the drawing.

The secondary winding assembly 8 is arranged around the central portion of the head insulating body 13. The winding assembly 8 is enclosed at the sides and at the outer surface by an electrically conductive winding shield 17 which, together with the outermost of the layers 16 of the head insulating body 13, is electrically connected to ground through the secondary winding tube 6 or through one of the secondary winding leads 7. The winding shield 17 is made of metal or polymer material with an electrically conductive filler. The winding shield 17 can also be made from paper filled with electrically conductive particles, e.g. carbon black, or from a woven or nonwoven material made of electrically conductive fibers.

The external surface of the head insulating body 13 and the external surface of the winding shield 17 attach to the insulating member 18 created by casting a hardenable resin into a mold, not shown in the drawing, which mold has a shape designed as the shape of the head 3. Alternatively, the mold can have a shape designed as the shape of the head 3 and the column 2. In this case, during molding the resin is penetrating through the pores or holes located in the spacer sheet 9 of the column insulating body 11 making the impregnation of the column insulating body 11 and forming the insulating member 18 in one process. After the resin is hardened and the mold is taken away the insulation member 18 has a form of the head 3 and is firmly connected with the column 2 of the current transformer 1. During the process of hardening of the resin the chemical and thermal shrinkage of the resin forming the insulating member 18 causes the resin material to tightly press to the outer surfaces of the head insulating body 13, to the winding shield 17 and to the external surface of the column insulating body 11, thus forming a void-free electrical insulation system having high dielectric strength and being free from partial discharges. The resin applied for producing the insulating member 18 and that used for the impregnation of the insulating bodies 13 and 11 is preferably an epoxy resin filled with inorganic filler material, for example a quartz powder. The spacer material used for winding the insulating bodies 13 and 11 is preferably a porous mesh or a woven or non-woven fabric made of polymer fibers. The pores or the openings between the fibers in the fabric are larger than the size of the particles of the inorganic filler material applied in the resin, so that the filled resin can thoroughly impregnate the spacer sheet material wound in the insulating bodies 13 and 11.

The filled resins used for casting the insulating member 18 and that used for impregnation of the insulating body 11 are either identical to each other or are resins filled with the same filler material in a similar amount so that the thermal expansion coefficients of both resins are identical. Other filled resin mixtures can also be used provided that their thermal expansion coefficients do not differ significantly within the operation temperature range of the instrument transformer. Not a significant difference is understood as the difference leading to mechanical stresses in the structure of the instrument transformer significantly smaller than the mechanical strength of the resin material when the temperature is changed to the maximum or to the minimum operating temperature of the instrument transformer.

The head 3 is covered from outside by an electrically conductive encapsulation 19 of the current transformer 1 which adheres firmly to the outer surface of the insulating member 18. The conductive encapsulation is made in a form of an electrically conductive paint, preferably based on epoxy resin filled with conductive particles, e.g. carbon black. Alternatively the conductive encapsulation 19 can be made in a form of a prefabricated metal mesh or grid which is positioned in the mold close to its inside surface prior to casting the resin forming the insulator member 18 and being embedded in the outer surface of the resin forming the insulating member 18 in the casting process. The conductive encapsulation 19 is electrically connected to the innermost of the layers 16 of the head insulating body 13, which innermost layer is electrically connected to the tube 14 and to the primary conductor 12. The electrical connections are made in such a way that the primary conductor 12 is connected to the encapsulation 19 only at one side of the conductor 12, so as to prevent part of the primary current from flowing through the encapsulation 19.

Alternatively, the primary winding can also be made with more turns, what is not shown in the drawing, with its conductor passing twice or more times through the head insulating body 13 and returning back through the space external to the conducive encapsulation 19.

For mechanical protection the head with the encapsulation 19 can be placed in an additional rigid extrernal enclosure, not shown in the drawing, for example made of metal, and being electrically connected to the encapsulation. Then, if the primary winding makes more than half turn, the primary winding conductor returns through the space between the condcutive encapsulation 19 and the external enclosure.

The side surface of the column 2 is covered by the external insulator 5 of the column 2, having many weather sheds and being made of silicone elastomer. The mold for casting the insulating member 18 and the impregnation of the column insulating body 11 can also have a special shape with cavities for forming the sheds so that the external insulator 5 can be also molded in one process. In such case the external insulator 5 of the column 2 with the sheds is made of the same material as that used for the insulating member 18. The column 2 comprises a bottom conductive flange 20. The bottom conductive flange 20 is mounted on a grounded box not shown in the drawing.

The voltage transformer 21 comprises a magnetic core 22 with a secondary winding 23 and primary winding 24. The primary winding 24 is made as a solid block, wound in layers on a primary winding tube 25 to an elongated shape and is impregnated with a hardenable resin, for example based on epoxy resin, and hardened. Alternatively the primary winding 24 can be wound on a mandrel which is withdrawn after hardening the resin which results in a winding 24 having a form of a solid block without the tube, which embodiment is not shown in the drawing. The outer end of the primary winding 24 is connected with a primary winding lead 26 having a form of a tube, which is placed in an inner part 27 of the insulating column 28. Around the primary winding lead 26 a block of spacer sheet 30 is wound, together with field-grading layers 31 inserted in between the sheets of the spacer and having outwardly diminishing axial length, forming a column insulating body 29 of the voltage transformer 21. After winding, the column insulating body 29 is impregnated with hardenable resin in a suitable mold and hardened forming the inner part 27 of the column 28 of the voltage transformer.

The external surface of the primary winding 24 attaches to the insulating member 32 of the voltage transformer created by casting a hardenable resin into a mold, not showing in the drawing, which mold has a shape designed as the shape of the insulating member 32. Alternatively, the mold can have a shape designed as the shape of the insulating member 32 and the column 28. In this case, during molding the resin is penetrating through the pores or holes located in the spacer sheet 30 of the column insulating body 29 making the impregnation of the column insulating body 29 and forming the insulating member 32 in one process. After the resin is hardened and the mold is taken away the insulating member 32 is firmly connected with the column 28 of the voltage transformer 21. During the process of hardening of the resin the chemical and thermal shrinkage of the resin forming the insulating member 32 causes the resin material to tightly press to the outer surfaces of the primary winding 24 and to the external surface of the column insulating body 29, thus forming a void-free electrical insulation system having high dielectric strength and being free from partial discharges. The resin applied for producing the insulating member 32 and that used for the impregnation of the insulating body 29 is preferably an epoxy resin filled with inorganic filler material, for example a quartz powder. The primary winding is impregnated with a similar epoxy resin, filled or unfilled. The spacer material used for winding the insulating body 29 is preferably a porous mesh or a woven or non-woven fabric made of polymer fibers. The pores or the openings between the fibers in the fabric are larger than the size of the particles of the inorganic filler material applied in the resin, so that the filled resin can thoroughly impregnate the spacer sheet material wound in the insulating body 29.

The filled resins used for casting the insulating member 32 and that used for impregnation of the insulating body 29 are either identical to each other or are resins filled with the same filler material in a similar amount so that the thermal expansion coefficients of both resins are identical. Other filled resin mixtures can also be used provided that their thermal expansion coefficients do not differ significantly within the operation temperature range of the instrument transformer. Not a significant difference is understood as the difference leading to mechanical stresses in the structure of the of the instrument transformer significantly smaller than the mechanical strength of the resin material when the temperature is changed to the maximum or to the minimum operating temperature of the instrument transformer.

The magnetic core 22 and the secondary winding 23 are assembled in the opening of the primary winding 24 after casting and hardening of the insulating member 32. The insulating member 32 is covered from outside by an electrically conductive encapsulation 33 of the voltage transformer 21 which adheres firmly to the outer surface of the insulating member 32. The conductive encapsulation is made in a form of an electrically conductive paint, preferably based on epoxy resin filled with conductive particles, e.g. carbon black. Alternatively the conductive encapsulation 33 can be made in a form of a prefabricated metal mesh or grid which is positioned in the mold close to its inside surface prior to casting the resin forming the insulator member 32 and being embedded in the outer surface of the resin forming the insulating member 32 in the casting process. The conductive encapsulation 33 is electrically connected to the inner end of the primary winding 24 which is grounded.

The insulating member 32, the windings 23 and 24 and the core can be placed in a grounded box, preferably made of metal, firmly mounted to the column 28 and forming in the same time the support of the voltage transformer 21, what is not shown in the drawing. The primary winding lead 26 is at its top connected with a HV terminal of the voltage transformer 35 protruding from the top of the column 28. The HV terminal 35 can be made also in different known manners, for example including also a conductive shielding head or ring which is not shown in the drawing.

The side surface of the column 28 is covered by the external insulator 34 of the column 28, having many weather sheds and being made of silicone elastomer. The mold for casting the insulating member 32 and the impregnation of the column insulating body 29 can also have a special shape with cavities for forming the sheds so that the external insulator 34 can be also molded in one process. In such case the external insulator 34 of the column 28 with the sheds is made of the same material as that used for the insulating member 32.

### KEY TO THE SYMBOLS IN THE DRAWINGS:

1 - current transformer
2 - column of current transformer
3 - transformer head
4 - inner part of the column of the current transformer
5 - external insulator of the current transformer
6 - secondary winding lead tube
7 - secondary winding leads
8 - secondary winding assembly
9 - first block of spacer sheet
10 - field-grading layers of column insulating body of current transformer
11 - column insulating body of current transformer
12 - primary conductor
13 - head insulating body
14 - primary conductor tube
15 - second block of spacer sheet
16 - field-grading layers of head insulating body of current transformer
17 - electrically conductive winding shield
18 - insulating member of current transformer
19 - conductive encapsulation of current transformer
20 - bottom conductive flange
21 - voltage transformer
22 - magnetic core
23 - secondary winding
24 -primary winding
25 - tube of primary winding
26 - primary winding lead
27 - inner part of the column of voltage transformer
28 - insulating column of voltage transformer
29 - column insulating body of voltage transformer
30 - insulating sheet-like spacer of column insulating body of voltage transformer
31 - field grading layers of column insulating body of voltage transformer
32 -insulating member of voltage transformer
33 - conductive encapsulation of voltage transformer
34 - external insulator of voltage transformer
35 - HV terminal

## Claims

1. HV dry instrument transformer having the form of a current transformer (1) or a voltage transformer (21) in which the current transformer (1) is provided with a column (2) comprising a column insulating body (11) for electric insulation of leads (7) of a secondary winding assembly (8), the voltage transformer (21) is provided with a column (28) comprising a column insulating body (29) for electric insulation of a lead (26) of its primary winding (24), wherein the column insulating body (11) of the current transformer column (2) and the column insulating body (29) of the voltage transformer column (28) are in contact with a head insulating member (18), (32), **characterised in that** the column insulating body (11, 29) has the form of a dry capacitor bushing wound as a block of spacer sheet (9, 30), respectively, the current transformer (1) has a head insulating body (13) for electrical insulation of the secondary winding assembly (8) from the primary winding conductor (12) of the currant transformer (1), the said head insulating body (13) having the form of a dry capacitor bushing and being in contact with the insulating member (18), whereas the voltage transformer (21) has said primary winding (24) being in contact with the insulating member (32), wherein the column insulating body (11, 29) has an impregnation material having substantially the same coefficient of thermal expansion as the material of the insulating member (18, 32).

2. High-voltage instrument transformer according to claim 1, **characterized in that** the insulating member (18, 32) is made of an inorganic-filled hardenable resin.

3. High-voltage instrument transformer according to claim 1 or 2, **characterized in that** the impregnation material for impregnating the column insulating body (11, 29) is an inorganic-filled hardenable resin.

4. High-voltage instrument transformer according to claim 3, **characterized in that** the impregnation material for impregnating the head insulating body (13) is an inorganic-filled hardenable resin.

5. High-voltage instrument transformer according to claims 2-4, **characterized in that** the inorganic- filled hardenable resin is an epoxy resin filled with quartz powder.

6. High-voltage instrument transformer according to claims 2-5, **characterized in that** the head insulating body (13) and the column insulating body (11, 29), have grading layer systems with field grading layers (10, 16) for the current transformer (1) or field grading-layers (31) for the voltage transformer (21) for capacitive field control and in each grading system the field-grading layers (10, 16) or field grading-layers (31), respectively, are spaced from each other by a first and second block of spacer sheet (9,15) for the current transformer (1) or by a block of spacer sheet (30) of the column insulating body (29) for the voltage transformer.

7. High-voltage instrument transformer according to claim 6, **characterized in that** the block of spacer sheet (9), (15) or (30) is made of polymer fibers.

8. High-voltage instrument transformer according to claims 1-7, **characterized in that** the outer surface of the secondary winding assembly (8) is covered by an electrically conductive winding shield (17)

9. High-voltage instrument transformer according to claim 8, **characterized in that** the winding shield (17) is made of metal or of electrically conductive polymer material or is made from paper filled with conductive particles or woven or nonwoven material made of electrically conductive fibers.

10. High-voltage instrument transformer according to claim 1-9, **characterized in that** the outer surface of the insulating member (18, 32) is covered by an electrically conductive encapsulation (19, 33).

11. High-voltage instrument transformer according to claim 10, **characterized in that** the electrically conductive encapsulation (19, 33) is made of an electrically conductive paint.

12. High-voltage instrument transformer according to claim 11, **characterized in that** the electrically conductive paint is based on epoxy resin filled with electrically conductive particles, preferably carbon-black.

13. High-voltage instrument transformer according to claim 10, **characterized in that** the electrically conductive encapsulation (19, 33) is made as a metallic mesh or grid embedded in the outer surface of the material forming the insulating member (18, 32).

14. High-voltage instrument transformer according to any of the previous claims, **characterized in that** it has an external insulator (5) of the column (2) of the current transformer (1) or an external insulator (34) of the column (28) of the voltage transformer (21) which is made of a silicon elastomer directly molded on the inner part (4) of the column (2) of the current transformer or on the inner part (27) of the column (28) of the voltage transformer.

15. High-voltage instrument transformer according to claim 1, **characterized in that** it has an external insulator (5) of the column (2) of the current transformer (1) or an external insulator (34) of the column (28) of the voltage transformer (21) which is made of an inorganic-filled hardenable resin.

## Patentansprüche

1. Der Hochspannungstrockeninstrumentenwandler hat die Form eines Stromwandlers (1) oder eines Spannungswandlers (21), wobei der Stromwandler (1) mit einer Säule (2) ausgerüstet ist, die einen Säulen-Isolanten (11) zur elektrischen Isolierung der Zuleitungen (7) der Sekundärwicklung (8) besitzt, und wobei der Spannungswandler (21) mit einer Säule (28) ausgerüstet ist, die einen Säulen-Isolanten (29) zur elektrischen Isolierung der Zuleitungen (26) seiner Primärwicklung (24) besitzt, wobei der Säulen-Isolant (11) der Stromwandlersäule (2) und der Säulen-Isolant (29) der Spannungswandlersäule (28) in Kontakt mit einem den Kopf isolierenden Bauteil (18), (32) stehen, **dadurch gekennzeichnet, dass** der Säulen-Isolant (11, 29) die Form einer Trockenkondensator-Durchführung hat, die als Block aus einer Trennschicht (9, 30) entsprechend aufgewickelt ist; der Stromwandler (1) hat einen oberen Kopfisolanten (13) zur elektrischen Isolierung der Sekundärwicklung (8) von der Primärwicklungs-Zuführung (12) - und der besagte obere Kopfisolant (13) hat die Form einer Trockenkondensator-Durchführung und steht in Kontakt mit dem isolierenden Bauteil (18), während der Spannungswandler (21) die besagte Primärwicklung (24) hat, die in Kontakt mir dem isolierenden Bauteil (32) steht, wobei der Säulen-Isolant (11, 29) ein Imprägnierungsmaterial besitzt, das tatsächlich den gleichen Wärmeausdehnungs-Koeffizienten hat wie das isolierende Bauteil (18, 32).

2. Hochspannungsinstrumentenwandler gemäß Anspruch 1, **dadurch gekennzeichnet, dass** das isolierenden Bauteil (18, 32) aus einem anorganisch ergänzten härtbaren Harz hergestellt ist.

3. Hochspannungsinstrumentenwandler gemäß Anspruch 1 oder 2, **dadurch gekennzeichnet, dass** das Imprägnierungsmaterial zur Imprägnierung des Säulen-Isolanten (11, 29) ein anorganisch ergänztes härtbares Harz ist.

4. Hochspannungsinstrumentenwandler gemäß Anspruch 3, **dadurch gekennzeichnet, dass** das Imprägnierungsmaterial zur Imprägnierung des oberen Kopfisolanten (13) ein anorganisch ergänztes härtbares Harz ist.

5. Hochspannungsinstrumentenwandler gemäß Anspruch 2-4, **dadurch gekennzeichnet, dass** das anorganisch ergänzte härtbare Harz ein mit Quarzpulver angereichertes Epoxidharz ist.

6. Hochspannungsinstrumentenwandler gemäß Anspruch 2-5, **dadurch gekennzeichnet, dass** der obere Kopfisolant (13) und der Säulen-Isolant (11, 29) Schichtsysteme der Feldgestaltung besitzen, mit Schichten, die das Feld gestalten (10, 16) für den Stromwandler (1) oder mit Schichten, die das Feld gestalten (31) für den Spannungswandler (21) zur kapazitiven Feldgestaltung, wobei in jedem System der Feldgestaltung die Schichten, die das Feld gestalten (10, 16) bzw. entsprechend Schichten, die das Feld gestalten (31) voneinander durch einen ersten und zweiten Block von Trennschichten (9, 15) für den Stromwandler (1) oder durch einen Block von Trennschichten (30) des Säulen-Isolanten (29) für den Spannungswandler getrennt sind.

7. Hochspannungsinstrumentenwandler gemäß Anspruch 6, **dadurch gekennzeichnet, dass** der Block von Trennschichten (9, 15, 30) aus polymeren Fasern gemacht ist.

8. Hochspannungsinstrumentenwandler gemäß Anspruch 1-7, **dadurch gekennzeichnet, dass** die Außenfläche der Sekundärwicklung (8) mit einem elektrisch leitenden Wicklungsschutz (17) bedeckt ist.

9. Hochspannungsinstrumentenwandler gemäß Anspruch 8, **dadurch gekennzeichnet, dass** der Wicklungsschutz (17) aus Metall oder aus einem elektrisch leitenden polymeren Material besteht oder aus mit leitenden Partikeln angereichertem Papier oder aus einem gewebten oder nicht gewebten Stoff gemacht ist, das aus elektrisch leitenden Fasern besteht.

10. Hochspannungsinstrumentenwandler gemäß Anspruch 1-9, **dadurch gekennzeichnet, dass** die äußere Oberfläche des Isoliermaterials (18, 32) durch eine elektrisch leitende Verkapselung (19, 33) bedeckt ist.

11. Hochspannungsinstrumentenwandler gemäß Anspruch 10, **dadurch gekennzeichnet, dass** die elektrisch leitende Verkapselung (19, 33) aus elektrisch leitender Farbe besteht.

12. Hochspannungsinstrumentenwandler gemäß Anspruch 11, **dadurch gekennzeichnet, dass** die elektrisch leitende Farbe auf Epoxidharz basiert, das mit elektrisch leitenden Partikeln angereichert ist, vorzugsweise Kohlenschwarz (carbon-black).

13. Hochspannungsinstrumentenwandler gemäß Anspruch 10, **dadurch gekennzeichnet, dass** die elektrisch leitende Verkapselung (19, 33) als ein Netz oder Gitter hergestellt ist, das in die äußere Oberfläche des Isoliermaterials (18, 32) eingebettet ist.

14. Hochspannungsinstrumentenwandler gemäß irgendeinem der vorherigen Ansprüche, **dadurch gekennzeichnet, dass** er eine äußere Isolierung (5) der Säule (2) des Stromwandlers (1) oder eine äußere Isolierung (34) der Säule (28) des Spannungswandlers (21) besitzt, die aus einem Silicon-Elastomer besteht, das direkt auf dem inneren Teil (4) der Säule (2) des Stromwandlers oder auf dem inneren Teil (27) der Säule (28) des Spannungswandlers geformt ist.

15. Hochspannungsinstrumentenwandler gemäß Anspruch 1, **dadurch gekennzeichnet, dass** er eine äußere Isolierung (5) der Säule (2) des Stromwandlers (1) oder eine äußere Isolierung (34) der Säule (28) des Spannungswandlers (21) besitzt, die aus einem härtbaren Harz mit anorganischen Füllstoff hergestellt ist.

## Revendications

1. Transformateur de mesure sec à haute tension sous forme d'un transformateur de courant (1) ou d'un transformateur de tension (21), où le transformateur de courant (1) est muni d'une colonne (2) comprenant un isolateur de la colonne (11) pour assurer l'isolation électriques des bornes (7) de l'enroulement secondaire (8), alors que le transformateur de tension (21) est muni d'une colonne (28) comprenant l'isolateur de la colonne (29) pour assurer l'isolation électrique des bornes (26) de son enroulement primaire (24), étant entendu que l'isolateur de la colonne (11) de la colonne du transformateur de courant (2) ainsi que l'isolateur de la colonne (29) de la colonne du transformateur de tension (28) adhèrent à l'élément isolant de la tête (18), (32), **caractérisé en ce que** l'isolateur de la colonne (11, 29) a la forme de sortie sèche du type condenseur enroulée sous forme d'un bloc des couches de séparation (9, 30) respectivement ; le transformateur de courant (1) possède l'isolateur de la tête (13) pour assurer l'isolation électrique de l'enroulement secondaire (8) contre le transformateur de l'enroulement primaire (12) et ledit isolateur de la tête (13) a la forme de sortie sèche du type condenseur et adhère à l'élément isolant (18), alors que le transformateur de tension (21) a l'enroulement primaire (24) adhérant à l'élément isolant (32), où l'isolateur de la colonne (11, 29) possède un matériel d'imprégnation de coefficient d'expansion thermique substantiellement le même que le coefficient d'extension thermique du matériel de l'élément isolant (18, 32).

2. Transformateur de mesure sec à haute tension selon la revendication 1, **caractérisé en ce que** l'élément isolant (18, 32) est fait en résine durcissable à charge inorganique.

3. Transformateur de mesure sec à haute tension selon les revendications 1 et 2, **caractérisé en ce que** le matériel d'imprégnation servant à l'imprégnation de l'isolateur de la colonne (11, 29) est une résine durcissable à charge inorganique.

4. Transformateur de mesure sec à haute tension selon la revendication 3, **caractérisé en ce que** le matériel d'imprégnation servant à l'imprégnation de l'isolateur de la tête (13) est une résine durcissable à charge inorganique.

5. Transformateur de mesure sec à haute tension selon les revendications 2 à 4, **caractérisé en ce que** la résine durcissable à charge inorganique est une résine époxyde avec poudre quartzeuse.

6. Transformateur de mesure à haute tension selon les revendications 2 à 5, **caractérisé en ce que** l'isolateur de la tête ((13) et l'isolateur de la colonne (11, 29) ont un système de classement de champ par couches avec les couches classifiant le champ (10, 16) pour le transformateur de courant (1) ou ave les couches classifiant le champ (31) pour le transformateur de tension (21) destinées à la classification capacitive de champ et dans chaque système de classement de champ, les couches classifiant le champ (10, 16) ou respectivement les couches classifiant le champ (31) sont séparées les unes des autres avec un premier ou deuxième bloc de couches de séparation (9, 15) pour le transformateur de courant (1) ou par un bloc de couches de séparation (30) de l'isolateur de la colonne (29) pour le transformateur de tension (21).

7. Transformateur de mesure à haute tension selon la revendication 6, **caractérisé en ce que** le bloc de couches de séparation (9, 15, 30) est fait en fibres polymères.

8. Transformateur de mesure à haute tension selon les revendications 1 à 7, **caractérisé en ce que** la surface extérieure de l'enroulement secondaire (8) est protégée d'un écran conducteur électriquement des enroulements (17).

9. Transformateur de mesure à haute tension selon la revendication 8, **caractérisé en ce que** l'écran des enroulements (17) est fait en métal ou d'un matériau polymère conducteur électriquement, ou en papier rempli de particules conductrices, ou encore d'un tissu ou d'un non-tissé faits de fibres conductrices électriquement.

10. Transformateur de mesure à haute tension selon les revendications 1 à 9, **caractérisé en ce que** la surface extérieure du matériau d'isolation (18, 32) est protégée par une enveloppe électriquement conductrice (19, 33).

11. Transformateur de mesure à haute tension selon la revendication 10, **caractérisé en ce que** l'enveloppe électriquement conductrice (19, 33) est faite d'une peinture électriquement conductrice.

12. Transformateur de mesure à haute tension selon la revendication 11, **caractérisé en ce que** la peinture électriquement conductrice est faite à base de résines époxydes remplies de particules électriquement conductrices, de préférence de noir de carbone.

13. Transformateur de mesure à haute tension selon la revendication 10, **caractérisé en ce que** l'enveloppe électriquement conductrice (19, 33) est faite en d'un filet en métal ou d'une grille noyée dans la surface extérieure de l'élément d'isolation (18, 32).

14. Transformateur de mesure à haute tension selon une quelconque des revendications précédentes, **caractérisé en ce que** qu'il a un isolateur extérieur (5) de la colonne (2) du transformateur de courant (1) ou un isolateur extérieur (34) de la colonne (28) du transformateur de tension (21) qui est fait en élastomère silicone modelé directement sur la partie intérieure (4) de la colonne (2) du transformateur de courant ou sur la partie intérieure (27) de la colonne (28) du transformateur de tension.

15. Transformateur de mesure à haute tension selon la revendication 1, **caractérisé en ce que** qu'il a un isolateur extérieur (5) de la colonne (2) du transformateur de courant (1) ou un isolateur extérieur (34) de la colonne (28) du transformateur de tension (21) qui est fait en résine durcissable à charge inorganique.
